# EUROPEAN PATENT SPECIFICATION

(11) **EP 2 559 022 B1**
(45) Date of publication and mention of the grant of the patent: **04.09.2013**
(21) Application number: 11730436.0
(22) Date of filing: 11.04.2011
(51) Int. Cl.: G09F 13/22, G09F 9/33, G09F 21/02

(54) **TEXTILE PRODUCT HAVING A LIGHTING FUNCTION AND METHOD FOR THE PRODUCTION THEREOF**
TEXTILPRODUKT MIT BELEUCHTUNGSFUNKTION UND HERSTELLUNGSVERFAHREN DAFÜR
PRODUIT TEXTILE AYANT UNE FONCTION D'ÉCLAIRAGE ET SON PROCÉDÉ DE FABRICATION

(30) Priority: 28.10.2010 EP 10189196; 16.04.2010 EP 10160191
(43) Date of publication of application: 20.02.2013
(73) Proprietor: Koninklijke Philips Electronics N.V., 5621 BA Eindhoven (NL)
(72) Inventor: VAN HERPEN, Maarten Marinus Johannes Wilhelmus, NL-5656 AE Eindhoven (NL); JOCHIJMS, Paul Antonius Emil, NL-5656 AE Eindhoven (NL); WILLEMSEN, Oscar Hendrikus, NL-5656 AE Eindhoven (NL)
(74) Representative: van Eeuwijk, Alexander Henricus Waltherus
(86) International application number: PCT/IB2011/051538
(87) International publication number: WO 2011/128825

(56) References cited:
- US-A1- 2003 211 797
- US-A1- 2006 255 433
- US-A1- 2009 201 672

## Description

### FIELD OF THE INVENTION

The invention relates to a textile product having a lighting function, as well as to a method for the production of such textile product. The invention further relates to a method of providing light with such textile product.

### BACKGROUND OF THE INVENTION

Textiles with electronic components are known in the art.

GB-2396252, for instance, describes a textile fabric comprises LEDs, for example surface mounted LEDs on a textile substrate which are individually encapsulated. The devices are connected between conductive tracks which may be yams woven in the fabric or tracks printed on the fabric, and may form a matrix- addressable display. An application given is to display images on clothing. The fabric remains flexible and washable.

Further, US-2006/0255433 describes a semiconductor-containing flexible skin suitable for use in intelligent textile applications, which includes a metal layer, an insulating layer, and one or more semiconductor islands sandwiched between a first flexible polymer layer and a second flexible polymer layer. Various electronics and sensors can be advantageously incorporated on the semiconductor islands. The metal layer of the invention is patterned into conducting paths that allow electrical communication between the semiconductor islands and to any devices connected to flexible skin. Moreover, the insulating layer is disposed between the metal layer and semiconductor islands. An intelligent textile includes the semiconductor-containing flexible skin attached to a fabric. Specifically, opening in the flexible textile allow direct weaving with textiles. A method of forming the flexible skin and intelligent fabric is also provided.

US-2009/0201672 describes light-emitting clothes in which the appearance of the clothes main body is provided with light emitting elements, a water-proof transparent layer being overcoated on the outside of the light emitting elements and the light emitting elements being electrically connected with a power source control box. According to this configuration, the water-proof transparent layer can assuredly prevent the light emitting elements from damage caused by the wetting from water.

Document US 2003/0211797 is considerd the closest prior art.

### SUMMARY OF THE INVENTION

In coated textiles, a textile carrier is coated with a protective layer such as PVC, PU, silicon or another plastic. The fabrics acquire specific technical qualities, such as becoming waterproof, micro porous, fireproof, anti-static, breathing, printable, etc., and offering protection against water, wind, cold and chemical products. Coated textiles are for example used in trucks (tarpaulin), in apparel, in tents and in architectural textiles.

Modern textiles are produced at low cost and high rates. This is done because weaving patterns are usually made only in the warp and weft directions. Unlike printed circuit boards, which use photolithographic techniques to define complex patterns, textile manufacturing does not allow a large degree of variance in line design.

By using conductive yarn in the warp and weft direction a woven matrix can be made consisting of rows and columns. If n rows and m columns are used, then n x m elements can be addressed. When light emitting elements, such as LEDs are connected to the fabric, a flexible textile can be made that emits light.

There is a desire to embed light sources, especially LEDs, in coated textiles. However, when this is done several problems may arise. For instance, since the light sources and conductor arrangement are also coated in the coating process they are also electrically insulated. This may make it very difficult to make an electronic connection to power the light sources. Further, it may not be allowed to make a hole through the textile in order to make an electrical connection, because the textile needs to be fully water tight. In addition, it may not be clear how light sources can be placed in a low-cost way onto the textile before the coating step. In addition, UV light may strongly lower the lifetime of the textile and for that reason an UV reflective and/or absorbing filler is added to the coating. However, this filler will also block some of the light generated by the light sources. Another problem may be that the textile will be cut at a certain length after it has been produced, but when this is done, electrical connections might be cut as well. Thus, the light sources need to keep on working after the textile has been cut to a desired length.

Hence, it is an aspect of the invention to provide an alternative textile product as well as an alternative method for producing such textile product, which preferably further at least partly obviate one or more of above-described drawbacks.

This invention aims amongst others to solve one or more of the above problems, using an embodiment in which a lighting unit is provided to the textile before it is coated. The lighting unit comprises a substrate, preferably with a conductor arrangement (herein also indicated as "electrically conductive connector") that is electrically connected to the light source(s) and which may optionally also be electrically connected to the textile. The invention may in an embodiment be characterized by the fact that the lighting unit comprises a connector that is (also) coated in the coating process. An advantage of this approach may be that the coating can be partially opened in order to connect to the conductor arrangement without the need to make a through hole in the textile. It may also allow the textile to be cut at any length.

In a first aspect, the invention provides a textile product according to claim 1 (herein also indicated as "coated textile product") having a lighting function, wherein the textile product comprises:
a. a coated textile structure ("structure" or "layered structure") comprising a textile with a first textile coating ("first coating") at a first side and optionally a second textile coating ("second coating") at a second side of the textile;
b. a lighting unit, especially a LED unit, comprising a substrate with a substrate surface and a light source, especially an LED, comprised by the substrate surface, wherein the lighting unit is arranged within the coated textile structure, and wherein the lighting unit is arranged to provide light ("light") through the first textile coating.

Preferably, the substrate surface further comprises an electrically conductive connector part ("connector"), wherein the connector part is arranged to supply electrical power to the light source when electrically connected to an electrical power source. Especially, this connector part is thus also coated by the first coating, as the connector is part of the lighting unit.

Advantages of arranging the lighting unit within the coated textile structure may amongst others be protection and flexibility. Advantages of including a connector in the lighting unit may be that only those connectors need to be approached by (electrical wires of) an external electrical power source. In addition, no through hole needs to be made, keeping the protective effect of the coated textile intact. The phrase "within the coated textile structure" thus especially indicates that the lighting unit is embedded in the structure and is, when the first coating is in tact, behind the first coating.

Hence, in contrast to a solution where a coating is only used locally at the position of the lighting unit, in the present invention substantially the entire textile is preferably coated (with at least the first coating), especially for its protective effect (air-tight, water-tight, etc). Hence, the first coating is preferably applied to at least 80 %, more especially at least 90%, even more especially at least 95 %, yet even more especially 100% of the entire surface (first side) of the textile. Likewise, the second coating is preferably applied to at least 80 %, more especially at least 90%, even more especially at least 95 %, yet even more especially 100% of the entire surface (second side) of the textile.

As mentioned above, the lighting unit is preferably a LED unit. Such LED unit is a unit comprising at least one LED (preferably solid state LED). Advantages of using LEDs are the small dimensions and the good life time of LEDs.

The light source is comprised by the surface, i.e. it may for instance be arranged on the substrate surface, it may be arranged in the substrate, or may partly be arranged in the substrate (and partly extend from the substrate surface).

In general, a "textile" is considered a flexible material consisting of a network of natural or artificial fibers often referred to as thread or yam. Textiles may for instance be formed by weaving, knitting, crocheting, knotting, or pressing fibers together (felt). The term "textile" may include fabric or cloth. The textile can be considered a carrier for the lighting unit(s). The term "textile" may also refer to a multi-layer textile, i.e. a textile comprising a plurality of textile layers adjacent to one another. Such multi-layer textile may thus be a laminate of textile layers.

The term "coated textile product" refers to generally known coated textile structures, which comprise a textile with a first textile coating at a first side and a second textile coating at a second side of the textile. In the invention however, the coated textile product further comprises the lighting unit. The textile product may be a product selected from the group of coated fabrics comprising a trailer textile, a (garden) furniture cover, a textile sailing, a tarpaulin, a curtain, an architectural outdoor textile, an architectural indoor textile, and a tent textile, etc. (and thus including the lighting unit according to the invention). However, also other applications are possible. Herein, the first coating is arranged at the light output side.

It may be advantageous to guide at least part of the light away from the lighting unit to other parts within the structure, where at those places light may (also) escape from the structure. In an embodiment, the layered structure (i.e. the coated textile structure) further comprises a light guide, arranged to guide at least part of the light of the light source away from the light source. Additionally or alternatively, the first coating may have such transmissive properties and the light source may be arranged in such a way (such as a side emitter light source), that light from the light source may at least partly travel also in the plane of the first coating through the first coating. In this way, the first coating may have (in plane) light guiding properties (see further also below).

Whether or not the structure and the light source(s) are arranged to provide light in the plane of the first coating, the first coating is preferably selected to have a sufficient transmission for the light to escape from the first coating, for the lighting unit is arranged to provide light ("light") through the first textile coating. The coating thickness and coating type (of the first coating) may be selected to facilitate transmission of the light of the light source (coated by the first coating).

Further, the type and amount of (optional) additives may be controlled, in order to control transmission. Fillers may lead to light loss. However, fillers are often also desired because of their properties. For instance, fire retardant, UV blockers, etc. may be included in the first and second coating. In an embodiment, the first coating substantially comprises no filler.

In a specific embodiment, the second textile coating further comprises a filler and the first textile coating comprises, relative to the total weight of the first textile coating, less filler than the second textile coating, preferably wherein the first textile coating comprises substantially no filler. Hence, in an embodiment the textile coating only comprises filler on one side of the textile (second coating), and does not comprise filler on the light-output side (first coating). When it is desired that the first coating has light guiding properties (in the plane of the coating), it may especially be desired that the amount of filler is low, or filler is even absent.

In an embodiment, the textile structure comprises both a first textile coating and a second textile coating. In general this is preferred in view of lifetime of the textile product.

The textile product may be connected to an electrical power source to provide electrical energy to the light source. This may for instance be done by removing only that part of the coating that protects (part of) the connector. Having done so, the connector may be connected to the electrical power source (via wires, and/or otherwise, see also below). The connector will thus in general have two electrically conducting parts that are electrically connected to the two electrodes (terminal pins) of the light source, and which parts are insulated from each other. The term "connector" thus refers to means to which an (external) electrical power source can be connected and that thus can be used to provide electrical power to the light source(s) of the lighting unit(s) and thereby allow generation of light by the light source(s). The connector may be arranged on the surface of the substrate (and thus extend from the substrate surface), may be arranged in the substrate or may partly be arranged in the substrate (and partly extend from the substrate surface).

In an embodiment, the connector may be a socket type connector. In another embodiment, the connector may be of a plug type connector. However, the connector may also include other means in or on the substrate to which electrical contact can be made and which are in electrically contact with the light source for powering the light source with electrical energy from an (external) electrical power source (when such power source is brought into electrical contact with the connector).

The term "electrically connected" and the phrase "when electrically connected to an electrical power source" may in an embodiment also relate to a wireless connection. For instance, a source connector may be applied that transfers wireless electrical energy (from a power source) to the connector comprised by the lighting unit.

The term "source connector" is applied to indicate that this connector provides electrical energy ("source" or "socket" or "sender"), whereas the connector comprised by the lighting unit only receives electrical energy, and can be considered a "receiver" (or "plug"). Without physical contact between the connector and the source connector, the lighting unit may be powered. This may be of interest if one desires not to modify the integrity of the textile product or one or more of its layers. In general, the source connector will be connected with electrical wires to the electrical power source.

The wireless transfer of electrical energy from the source connector to the connector may for instance be via inductive power transfer or via resonant inductive power transfer. In the latter case, both the sender and the receiver may be made resonant, in order to improve the efficiency of the power transfer. When using induction, both the source connector and connector may comprise one or more electrically conductive coils.

The wireless transfer of electrical energy from the source connector to the connector may for instance also be via (resonant) capacitive power transfer. Instead of using coils two electrode plates at both the sender and the receiver may then be needed.

In an embodiment, the source connector may be arranged on the first textile coating, opposite of the lighting unit (i.e. at least part of the first textile coating is between the source connector and connector and prevents physical contact between the connectors).

In yet another embodiment, the source connector is (also) embedded in the first textile coating, but is not in physical connection with the connector.

In another embodiment, the source connector is arranged between the substrate and the textile. In yet another embodiment, the source connector is arranged on the textile, opposite of the lighting unit (i.e. at least part of the textile is between the source connector and connector, and prevents physical contact between the connectors), i.e. at the first side.

In yet a further embodiment, the source connector is embedded in the textile (i.e. at least part of the textile is between the source connector and connector, and prevents physical contact between the connectors).

In yet another embodiment, wherein the second textile coating is present, the source connector is arranged between the textile and the second textile coating, and again, the source connector is arranged on the textile, opposite of the lighting unit (i.e. at least part of the textile is between the source connector and connector, and prevents physical contact between the connectors), such as (again) at the first side.

In yet a further embodiment, wherein the second textile coating is present, the source connector is embedded in the second textile coating (i.e. at least part of the second textile coating, and optionally also at least part of the textile, is between the source connector and connector, and prevents physical contact between the connectors).

In yet a further embodiment, wherein the second textile coating is present, the source connector is arranged on the second textile coating, opposite of the second side, (i.e. at least part of the second textile coating, and optionally also at least part of the textile, is between the source connector and connector, and prevents physical contact between the connectors).

Hence, the invention also provides an embodiment of the textile product further comprising an electrical power source, arranged in physical and electrical connection with the source connector, and arranged to supply electrical power to the light source via wireless electrical energy transfer from the source connector to the connector.

In an embodiment, the textile product may further comprise an electrical power source, arranged in electrical connection with the connector, and arranged to supply electrical power to the light source. As indicated above, this may be a wired connection, i.e. an electrical wire between the electrical source and the connector, but this may also a non-wired connection, i.e. an electrical wire (from the electrical power source to the source connector and wireless electrical energy transfer to the connector). This electrical power source will thus in general be arranged outside the structure and may be connected to the connector of the textile product in a detachable way. Before removal of the part of the coating that protects (part of) the connector, the connector is also "hidden" behind the coating since in a preferred embodiment, the lighting unit is coated with the first coating (thus including the connector). The connector may thus physically be connected to the (external) electrical power source or physically be connected to (external) conductive wires in electrical contact with the (external) electrical power source. Hence, when the textile product is connected to the electrical power source, in an embodiment at least one connector is not fully coated anymore, and is electrically connected, through the coating, with the electrical power source.

In an embodiment, the lighting unit comprises a plurality of electrically conductive connectors. This may advantageously provide more freedom to connect an (external) electrical power source to the lighting unit at a preferred place. Hence, in a specific embodiment, the term "connector" may also refer to a plurality of connectors on a single lighting unit.

In yet an embodiment, the lighting unit comprises a plurality of light sources, such as a plurality of LEDs. Hence, in a specific embodiment, the term light source may also refer to a plurality of light sources. The plurality of light sources may be arranged to provide light having substantially the same wavelength distribution (in the visible part of the spectrum), but the plurality of light sources may also be arranged to contain two or more subsets of light sources arranged to provide light having substantially different wavelength distributions (in the visible part of the spectrum).

As mentioned above, the lighting unit may comprise one or more connectors. Further, the lighting unit may comprise one or more light sources. However, additionally or alternatively, the textile product may also comprise a plurality of lighting units. Hence, one or more lighting units may be integrated in the textile product. An advantage of using more than one lighting unit may be that this may allow the cut-to-measure approach. The plurality of lighting units comprises one or more lighting units with connectors, respectively, but may in addition optionally also comprise one or more lighting units without connectors. In the former case, two or more lighting units may be in electrical contact with each other; in the latter case at least the lighting unit(s) without a connector are preferably arranged in electrical contact with a lighting unit having a connector. Preferably, where more than one lighting unit is applied in the textile product, all lighting units are in electrical contact with each other, for instance via conductive yarns. In this way, an electrical power source can be contacted to one single connector, and provide electrical energy to all lighting units.

In general, the plurality of light sources are arranged to provide light through the first textile coating.

By using conductive yarn in the warp and weft direction a woven matrix can be made consisting of rows and columns. If n rows and m columns are used, then n x m elements can be addressed. When light emitting elements, such as light sources are connected to the fabric, a flexible textile can be made that emits light. This approach is one embodiment in which conductive yarns are used.

However, the method of using rows and columns is not always the preferred solution. For example, when the light sources do not need to be controlled individually (like in general lighting applications), this is not the solution to be used, but a solution with only rows or only columns may then be preferred.

Electrical connection between two or more lighting units may be provided by conductive wires arranged within the structure. For instance, conductive wires may be arranged within the textile. Conductive wires may also be arranged on the textile (and are thus coated as well). In an embodiment, two or more lighting units are electrically connected by electrically conductive wires arranged within the coated textile structure. In a more specific embodiment, the textile comprises one or more electrically conductive yarns, wherein the one or more electrically conductive wires comprise the one or more conducting yarns.

In view of the cut-to-measure approach, it may be worthwhile to arrange more wires than strictly necessary. In this way, cutting the textile product may disrupt a conductive connection somewhere, but leave a conductive connection intact elsewhere. Hence, in an embodiment the textile product comprises supernumerary electrically conductive wires. Electrically conductive wire may thus in an embodiment be arranged in parallel to lighting units, respectively.

In a specific embodiment, the substrate is attached to the textile with a low-melting temperature solder. This may enable a method of producing the coated textile with embedded light sources, in which the lighting unit is placed onto the textile and is automatically soldered onto the textile using the heat that is applied in the coating step. Hence, in one embodiment the lighting unit comprises a layer of low melting-temperature solder on the backside of the lighting unit (backside of substrate), allowing a low cost method of providing the lighting unit onto the textile. This may be of especial interest when the textile comprises conductive yarns.

A low melting solder alloy may preferably melt at temperatures below 200°C and above 50°C (the temperature that is used is typically 180 - 190°C). Most of the alloys that meet this requirement comprise at least the following elements: Sn (tin), Pb (lead), Bi (bismuth), and In (indium). Sometimes also Ga (Gallium) may be added. Various compositions of these elements produce alloys that melt at any given temperature between 50°C and 183°C. As an example, 43Sn43Pb14Bi has a solidus temperature of 144°C and the liquidus temperature is 163°C. Another example is 40Sn40In20Pb. The solidus temperature of this alloy is 121°C and the liquidus temperature is 130°C.

In a further aspect, the invention provides a textile product having a lighting function, wherein the textile product comprises:
a. a coated textile structure comprising a textile with a first textile coating at a first side and optionally a second textile coating at a second side of the textile;
b. a lighting unit comprising a substrate with a substrate surface and a light source comprised by the substrate surface, wherein the lighting unit is (at least partly) arranged within the coated textile structure wherein the lighting unit is arranged to provide light through the first textile coating, wherein the lighting unit further comprises an electrically conductive connector part (in an embodiment extending from the substrate surface) wherein at least part of the electrically conductive connector part is not covered by the first coating, and wherein the connector part is arranged to supply electrical power to the light source when electrically connected (wired or wireless, see also above) to an electrical power source.

In yet another embodiment the connector is embedded within the substrate, and an electrical connection may be made by cutting through the connector from the outside. For example, the connector that is embedded could be a foil of copper, and the connection is made using a nail etc. that penetrates through the foil.

Here, in a preferred embodiment, the entire lighting unit may be hidden behind the first coating, except for at least part of the electrically conductive connector part, which protrudes the first textile coating. These embodiments may for instance relate to all previously described embodiments, but after removal of the coating on at least part of the electrically conductive connector part. In this way, the connector may partly protrude the coating and may be connected to an electrical power source. Hence, in a further embodiment, the textile product further comprises an electrical power source, arranged in physical and electrical connection with the connector, and arranged to supply electrical power to the light source. This electrical power source, as mentioned above, may be arranged outside the textile product.

In yet a further aspect, the invention provides a method for the production of a textile product as described herein, wherein the method comprises:
a. applying a lighting unit comprising a substrate with a substrate surface and a light source comprised by the substrate surface to a textile; and
b. coating the textile with the lighting unit in a first coating process with a first textile coating to provide a coated textile wherein the lighting unit is arranged to provide light through the first textile coating and optionally coating the textile in a second coating process with a second coating, with reference to the textile, opposite of the first textile coating, wherein the substrate surface further preferably comprises an electrically conductive connector part (optionally extending from the substrate surface), and wherein the connector part is arranged to supply electrical power to the light source when electrically connected (wired or wireless, see also above) to an electrical power source.

In this way, a coated textile may be provided wherein the lighting unit is also coated with the first coating. The fact that the application of the second coating is mentioned after application of the first coating does not necessarily include this sequence. As described herein, the sequence may also be the other way around.

In a specific embodiment, the method comprises arranging with a low-melting temperature solder the lighting unit on the textile and coating the textile and lighting unit with the first textile coating, whereby the low-melting temperature solder and the first coating process conditions are selected to melt the low-melting temperature solder during the first coating process.

With the textile product as described herein, light may be generated. Hence, in a further aspect, the invention provides a method of providing light with a textile product having a lighting function as describer herein, wherein the method comprises providing such textile product and an electrical power source, electrically connecting the electrical power source and the electrically conductive connector part, and providing electrical power to the light source.

The principle of the invention may also be extended to other components. For instance, other types of electronics may be embedded in coated textiles. For example, sensors may be embedded into the textiles, such as for example a light sensor, or a smoke detector. Another example of other electronics are communication systems, such as RFID detectors.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figs. 1a-1b schematically depict general embodiments of the coated textile structure and the lighting unit, respectively.
Figs. 2a-2b schematically depict some possible embodiments of the arrangement of the lighting unit;
Figs. 3a-3e schematically depict some embodiments of the lighting units, connectors and wired connections;
Figs. 4a-4d schematically depict some embodiments of the textile structure;
Figs. 5a-5b schematically depict possible methods for the production of the textile product;
Figs. 6a-6b schematically depict some possible end products; and
Figs. 7a-7b schematically depict some possible embodiments of the lighting unit when wireless electrical energy transfer is desired.

### DETAILED DESCRIPTION OF THE EMBODIMENTS

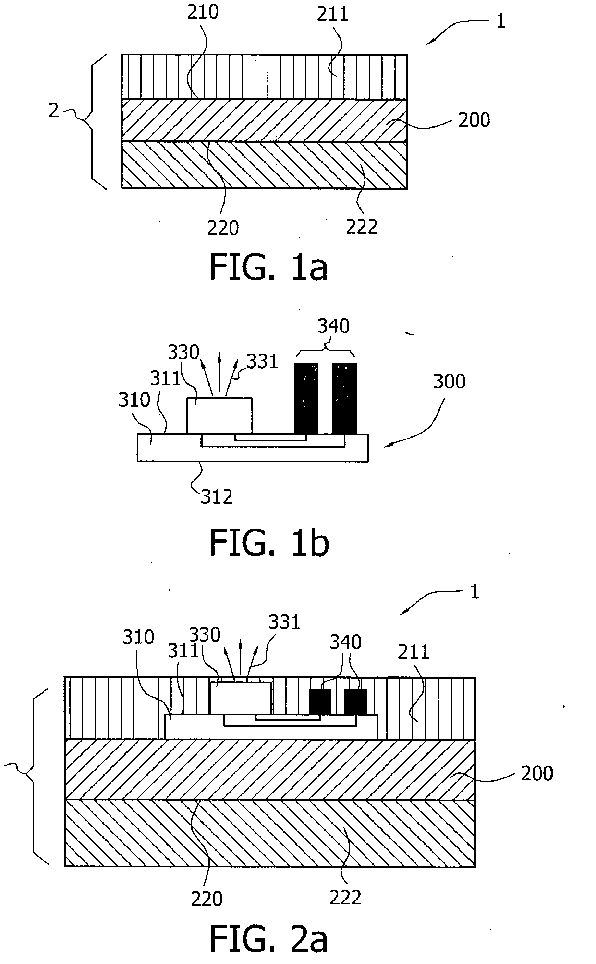

Figs. 1a-1b schematically depict general embodiments of the coated textile structure and the lighting unit, respectively.

Fig. 1a schematically depicts a textile product 1 in general comprising a coated textile structure 2. The coated textile structure 2 comprises a textile 200 with a first textile coating 211 at a first side 210 and a second textile coating 222 at a second side 220 of the textile 200. The second textile coating at the second side is optional, but will in general be present. The lighting unit is not displayed in this schematically drawing.

Fig. 1b schematically depicts a lighting unit 300 comprising a substrate 310 with a substrate surface 311 and a light source 330 comprised by the substrate surface 311. The light source is arranged to generate light 331. The lighting unit 300 further comprises an electrically conductive connector part (or "connector") 340, here extending from the substrate surface 311. The connector part 340 is arranged to supply electrical power to the light source 330 when electrically connected to an electrical power source (not depicted). As shown in the graph, the connector 340 is in electrical contact with the light source 330. The back side of the substrate 310 is indicated with reference 312.

As mentioned above, the connector 340 may be integrated in the substrate 310 or may extend from the substrate surface 311 (as depicted in most of the schematically depicted embodiments).

Figs. 2a-2b then schematically depict some possible embodiments of the arrangement of the lighting unit 300 within the textile structure 2. In both schematic drawings, the lighting unit 300 is arranged within the coated textile structure 2. The lighting unit 300 is arranged to provide light 331 through the first textile coating 211.

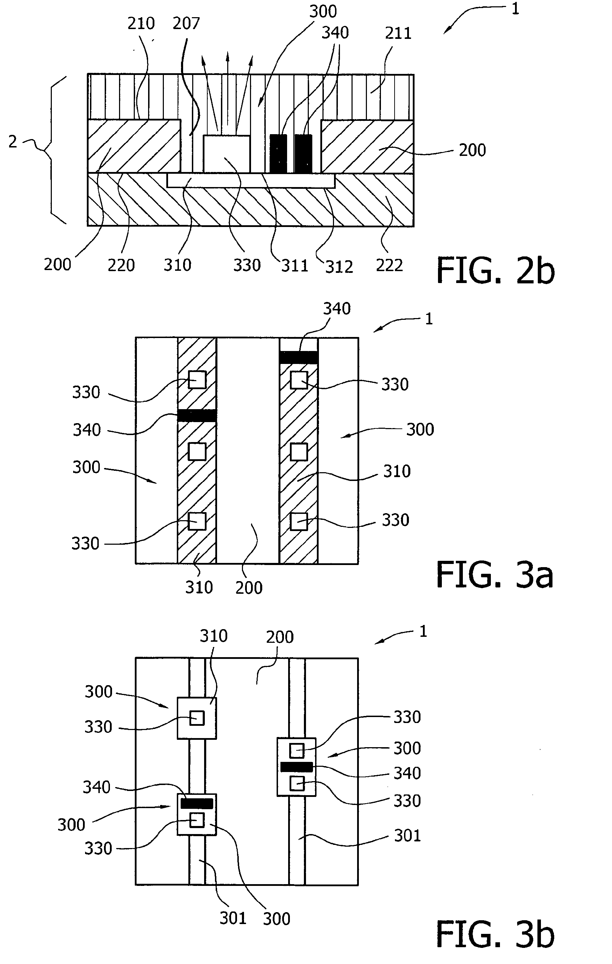

In Fig. 2a, the lighting unit 300 is arranged on the textile 200, i.e. the substrate 310 resides with its backside on the textile 200. In Fig. 2b, however, the lighting unit 300 at least partly resides in a cavity 207 (here through cavity) in the textile 200. When a through hole cavity 207 is applied, the lighting unit 300 may be coated at one side with the first coating 211 and may be coated at the other side with the second coating 222.

Hence, in some embodiments the lighting unit 300 may be coated with both the first coating 211 (at one side of the lighting unit 300) and with the second coating 222 (at the other side of the lighting unit 300).

Referring to amongst others Figs. 1a, 2a and 2b, those schematically depicted embodiments show embodiments wherein the first coating 211 is applied to about 100% of the surface (here first side 210) of the textile 200. Likewise, the second coating 222 is here applied to surface (here second side 220).

Figs. 3a-3e schematically depict some embodiments of the lighting units, connectors and wired connections.

Fig. 3a schematically depicts an embodiment, of the textile product 1, wherein the lighting unit 300 comprises a plurality of light sources 330. The substrate 310 is schematically depicted as strip. The connector 340 and the plurality of light sources 330 (on one substrate 310) may be arranged to allow providing electrical power via connector 340 to all light sources 330. By way of example, two substrates 310, with each a plurality of light sources 330 are depicted. Further, here, by way of example each substrate 310 has a connector 340, though this may not be necessary (as described herein).

Hence, single lighting unit(s) 300 may be provided in the structure 2, comprising a plurality of light sources 330 and optionally also a plurality of connectors 340. An advantage of such embodiments may be that this solution may have a higher reliability (longer lifetime), and an additional advantage may be that the system has a better efficiency due to a lower electrical resistance of copper wires compared with conductive yarns. This may also be indicated as light source string.

Fig. 3b schematically depicts an embodiment, wherein the textile product 1 further comprises a plurality of electrically conductive wires 301. These wires 301 may be embedded in the textile 200 or arranged on the textile 200 (at one or both sides 210 and 220, respectively). The wires 301 may be used to connect different lighting units 300. Hence, Fig. 3b schematically depicts an embodiment, wherein two or more lighting units 300 are electrically connected by electrically conductive wires 301 arranged within the coated textile structure 2. Hence, when connecting an external power source to connector 340 (on the right), both lighting units 300 on the left may be powered. Fig. 3b also schematically shows that in such embodiment, it is not necessary that all lighting units 300 have connectors 340.

Hence, lighting unit 300 may be electrically connected to these conductive wires 301, such as conductive yarns. The lighting unit 300 can then be connected to a power supply (not shown in Figs. 3a-3e) through the connector 340 which connector 340 is initially also embedded within the coating 211 (along with the entire lighting unit 300). The advantage of this embodiment may be that an external connector that matches with connector 340 may penetrate through the coating 211 in order to make an electrical connection. This may solve the problem of how to make an electrical connection. Also, no through hole may have to be made and thus the coated textile keeps its protective properties.

The lighting unit 300 may preferably be electrically, but preferably also be mechanically connected to the textile 200. A connection may for example be made with solder, or a nail that pins the lighting unit 300 onto the textile 200 and may also make the electrical contact.

The lighting unit 300 may typically comprise a PCB substrate. The PCB may be flexible, having a thickness of for instance 0.2 mm or less, but the PCB may also be thicker (for example 1 mm or thicker) in order to ensure the strength of the PCB when the textile is rolled up.

The plurality of lighting units 300, as schematically depicted here and in some other figures, may be connected to the same conductive wires 301, such as conductive yarns. The advantage of this approach may thus be that only one connector 340 needs to be connected to a power supply in order to provide all other lighting units with power. A further advantage of this embodiment is that the coated textile 1 can be cut at any desired length, after which an electrical connection can be provided. If any cuts are made through (for instance the conductive yarns), it is possible to make additional electrical connections to another connector 340 in order to restore functionality.

The invention may also provide a method of manufacturing coated textiles 1 with embedded light sources, comprising (a) providing a lighting unit 300 onto a textile 200 comprising conductive yarns, (b) providing a low melting temperature solder between the textile 200 and the lighting unit (300), and (c) providing the first coating 211 onto the textile 200 (at the first side 210) and lighting unit 300 (also at the first side 210), such that the heat of the coating process melts the solder and makes an electrical (and preferably also mechanical) connection between the conductive yarns and the lighting unit 300.

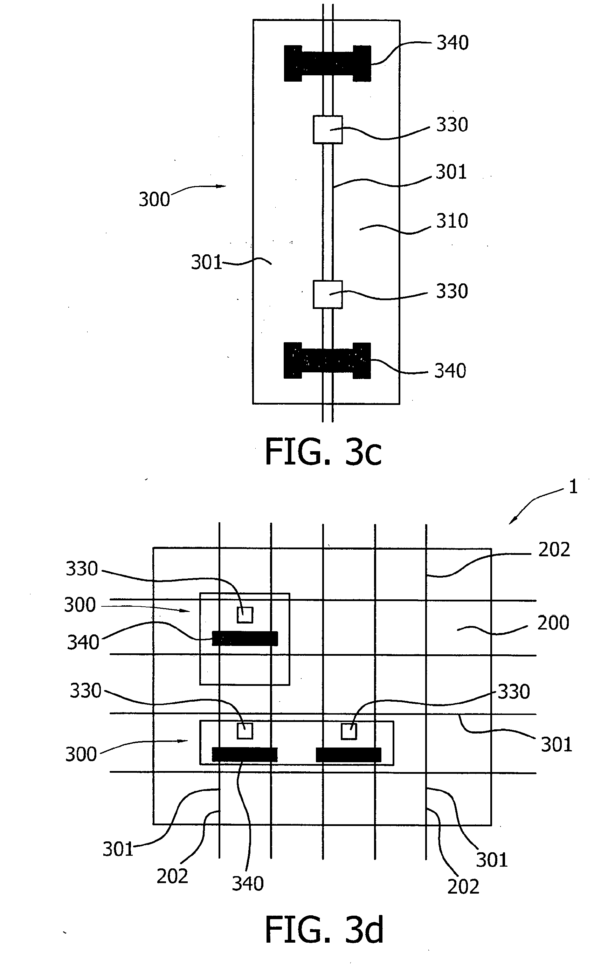

Fig. 3c schematically depict an embodiment of the lighting unit 300, comprising a plurality of light sources 330. Fig. 3c schematically depict an embodiment of the lighting unit 300, comprising a plurality of electrically conductive connectors 340. The light sources 330 and the connectors 340 are in electrical connection with each other, via electrically conductive wires 301. Hence, applying the appropriate voltage over one connector 340 may drive all connected light sources 330 (here by way of example two light sources 330 and two connectors 340 are schematically depicted). Please note that the schematic drawings herein may refer to parallel or series connection of the light sources 330.

Fig. 3d schematically depicts an embodiment of the textile product 1 having a plurality of conductive wires 301. Actually, here the textile product 1 comprises more conductive wires 301 than really necessary. Hence, the textile product 1 comprises supernumerary electrically conductive wires 301. In this schematic embodiment, light sources 330 may be powered via each individual connector 340, and may thus also be powered via a connector at another lighting unit 300, due to the electrically conductive wires 301. Due to the fact that more electrical wire 301 are provided than necessary, a cut somewhere may not immediately lead to a disruption of the circuit, but other (electrically parallel arranged) wires may be arranged to simply set this off. Hence, a redundancy of wires 301 may connected to the lighting unit(s) 300, in order to protect the device from malfunction when one of the wires 301 is damaged. This might happen, because a hole might be made accidentally in the textile. The advantage of this embodiment is that this hole can be patched and the light sources 330 will still receive power.

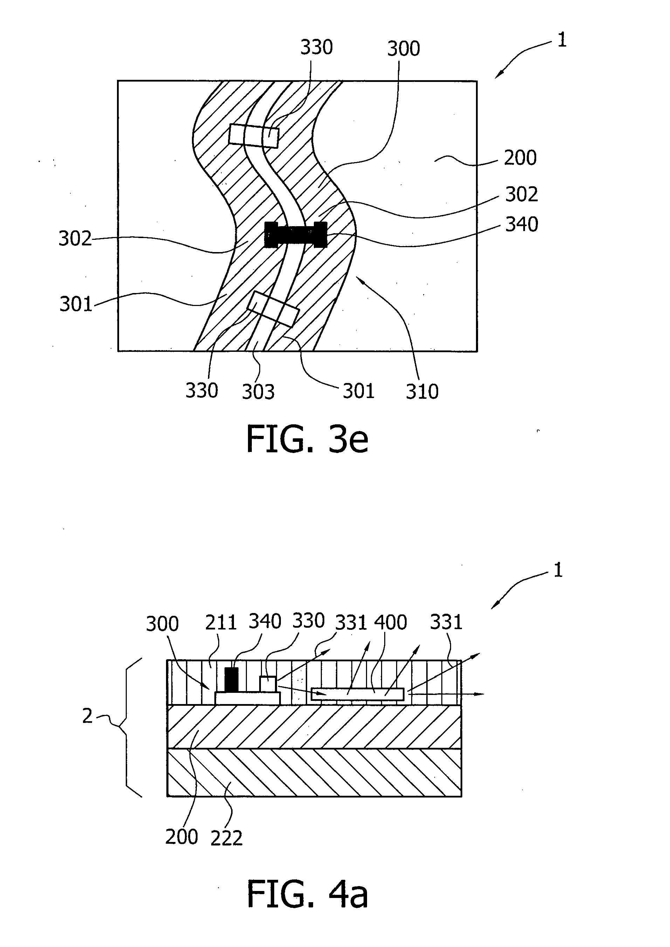

Fig. 3e schematically depicts a textile product I having a meandering type of lighting unit 300, i.e. the substrate 310. The substrate 310 here comprises two conducting wires 301, here as relative broad conductive strips, which have a meandering structure, and which a separated by an insulator 303. For instance, the conducting wires 301 may be arranged on a meandering substrate 310. An advantage of this embodiment may be that (thermal) expansion may at least partly be coped with. As will be clear to the person skilled in the art, the substrates 310 herein will in general be flexible.

Figs. 4a-4d schematically depict some embodiments of the textile structure.

Fig. 4a schematically depicts an embodiment wherein a side emitting light source 330 is applied. Note that also in other embodiments schematically depicted herein side emitters or top emitters may be applied. In the schematic embodiment of Fig. 4a, the structure 2 further comprises a light guide 400, arranged to guide at least part of the light 331 of the light source 330 away from the light source 330. In this way, light 331 may be distributed over part of the textile product 1. The light guide 400 may optionally include outcoupling sites, to promote outcoupling of light 331 (at desired positions).

Hence, the invention also provides an embodiment wherein the light 331 of the light source 330 is spread over a larger distance using a light guide 400 that is either embedded within the coated textile 1, or it is attached onto the coated textile such that the light of the light source is captured into the light guide. For instance, a light guide may however also be attached to the textile on the outside thereof, like a sticker. The advantage of the approach with a light guide 400 may be that glare may be reduced.

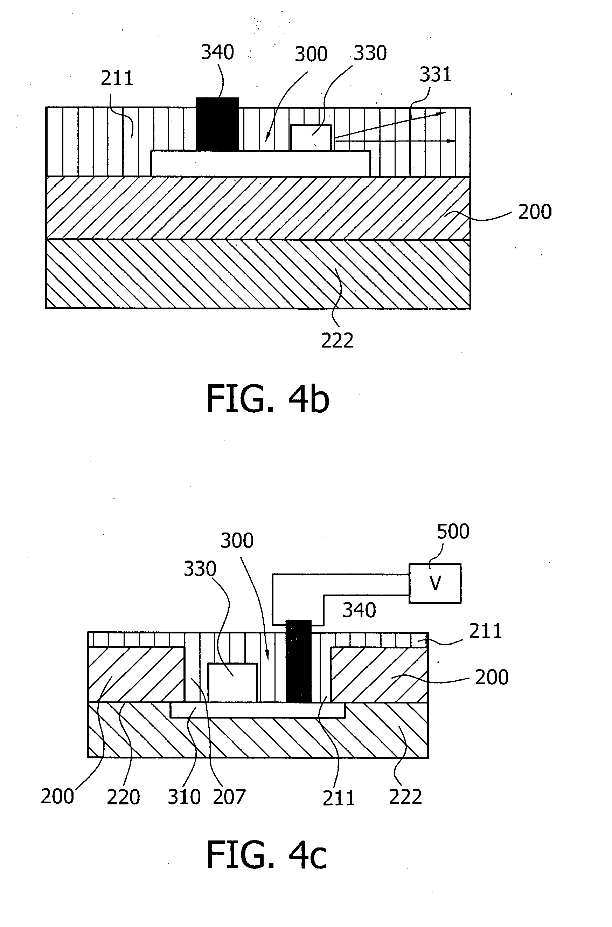

Fig. 4b schematically depicts the same embodiment as schematically depicted in Fig. 2a, but now part of the connector 340 is not hidden by the first coating 211. This may be due to a process wherein the connector is not fully coated with the first coating 211, but may especially be due to a process wherein the lighting unit 300 is (fully) coated with the first coating, thus also wherein the connector 340 is (fully) coated with the first coating 211, but whereafter part of the first coating 211 has been removed. After removal, the connector 340 can be connected to an electrical power source 500, as schematically depicted in Fig. 4c.

Hence, the invention also provides a method of providing electrical connection to the coated textile 1 comprising (a) making an opening in the first coating 211 of a coated textile 1, and (b) providing an electrical connection to an (external) electrical power source (for instance via a further connector) to the connector 340 that is embedded in the coated textile 1. These actions may in an embodiment also be done simultaneously, for example when a connector simultaneously cuts and makes the connection.

Please note that Fig. 4b by way of example schematically depicts an embodiment including a side emitting light source 330, and that Fig. 4c schematically depicts an embodiment wherein the lighting unit 300 at least partly resides in a cavity 207 in the textile 200.

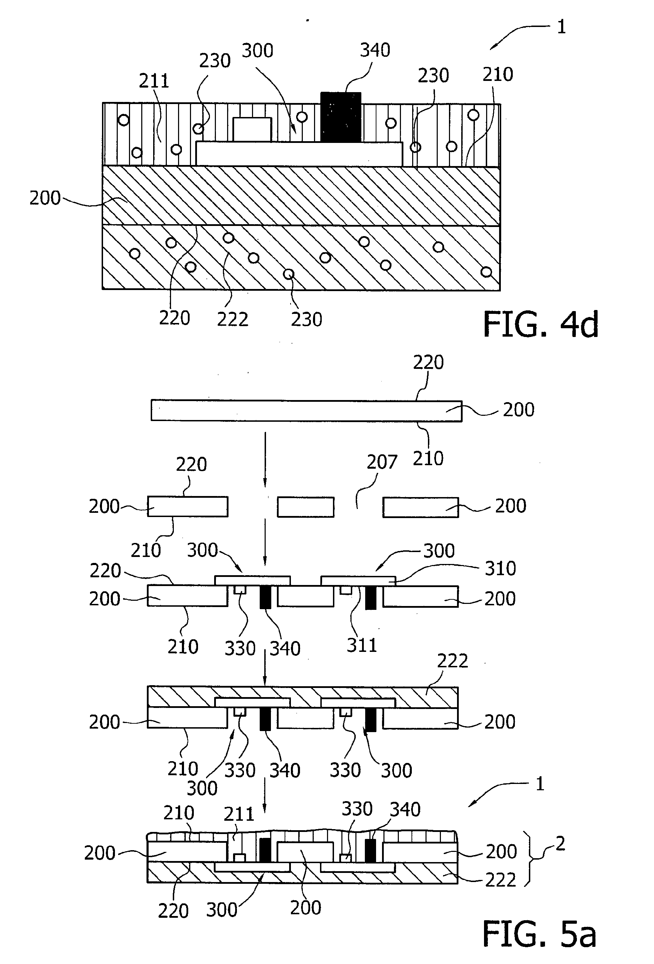

Fig. 4d schematically depicts an embodiment of the textile product 1, wherein the second textile coating 222 further comprises a filler 230 and wherein the first textile coating 211 comprises, relative to the total weight of the first textile coating 211,less filler 230 than the second textile coating 222, preferably wherein the first textile coating 211 comprises substantially no filler 230. Hence, the first and the second coating may be substantially identical in composition, but the filler content may be lower in the first coating 211 than in the second coating 222, especially, the first coating 211 may comprise no filler 230. Therefore, in an embodiment the textile coating may only comprise filler on one side of the textile, and does not comprise filler on the light-output side. In this way, the UV protection of the filler is still provided, but on the light-output side the light transmission may also be optimized.

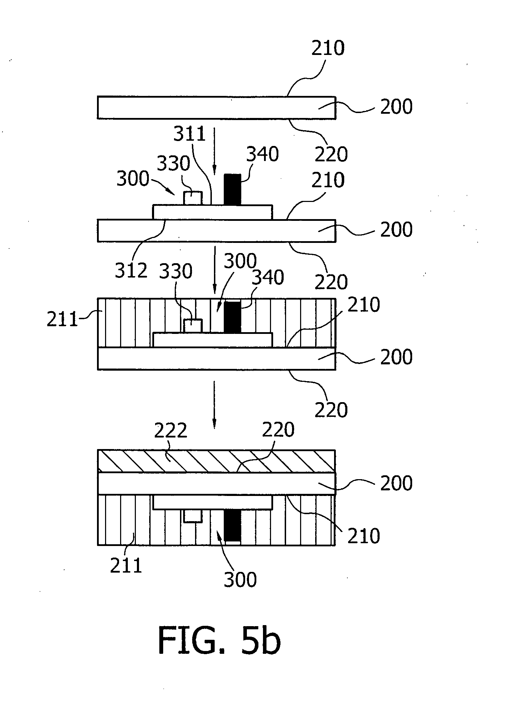

Figs. 5a-5b schematically depict possible methods for the production of the textile product. Fig. 5a schematically depicts a process wherein the lighting unit 300 is partly arranged in a cavity 207. In a first part of the process, cavities 207 may be created in textile 200. Then, from the top side, the lighting units 300 are arranged in the cavities 207, with the substrate 310 keeping the lighting unit 300 suspended in the cavity 207. The substrate face 311 is in contact with the second side 220. Then the second coating 222 is applied, by which the lighting units 300 are maintained in place in the cavities 207. Then, the unit obtained may be turned and coated with the first coating 211. In this way, an embodiment of textile product 1 may be obtained. Note that in this embodiment, first the second coating process is applied and then the first coating process. Fig. 5b schematically depicts a process wherein the lighting unit 300 is arranged on the textile 200. The back side 312 of the substrate is in physical contact with the first side 210 of the textile 200. After arranging the lighting unit(s) 300 on the textile, the first coating 211 can be provided (in a first coating process). Thereafter, the unit thus obtained may be turned, and the optional second coating 222 may be provided (in a second coating process). In this way, an embodiment of textile product 1 may be obtained. Note that the method embodiment as schematically depicted in Fig. 5b may also include cavity formation 207; however, in such embodiment, the cavity is not a through cavity. The lighting unit may 300 rest on the bottom of such cavity.

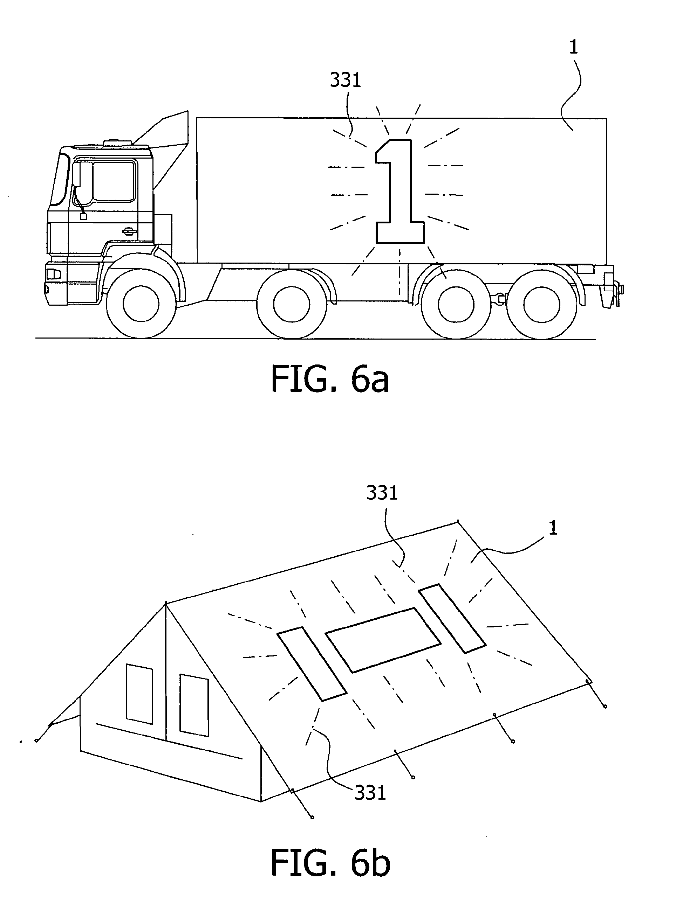

Figs. 6a-6b schematically depict some possible end products, wherein Fig. 6a schematically depicts a truck with a coated textile product 1 (here trailer textile) as described herein with a lighting function, and wherein Fig. 6a schematically depicts a tent with a coated textile product 1 (here tent textile) as described herein with a lighting function. Preferably the coated textile product is used for general lighting. For example, it could be used on the roof of the trailer, in order to illuminate the inside of the trailer. In another example, it is used to illuminate the interior of a tent.

Figs. 7a-7d schematically depict a non-limiting number of possible embodiments wherein the lighting unit may be wireless connected to a power supply (not shown).

In Fig. 7a, a source connector 540 is be arranged on the first textile coating 211, opposite of the lighting unit 330. Hence, at least part of the first textile coating 211 is between the source connector 540 and connector 340 and prevents physical contact between the connectors). Now, the connector 340 does not need to penetrate (locally) the textile coating 211 (see also figures 2a and 4b/4d).

In another embodiment, the source connector 540 is arranged between the substrate 310 and the textile 200, see Fig. 7b. In yet another embodiment (not depicted), wherein the second textile coating 222 is present, the source connector 540 is arranged between the textile 200 and the second textile coating 222.

Fig. 7c is a variant on Fig. 7a (see also Fig. 2b).

In yet a further embodiment, schematically depicted in Fig. 7d, wherein the second textile coating 222 is present, the source connector 540 is arranged on the second textile coating 222, opposite of the second side 220, (i.e. at least part of the second textile coating 222, and optionally also at least part of the textile 200 (which is here not the case), is between the source connector 540 and connector 340, and prevents physical contact between the connectors). A variant (not depicted) of the embodiment schematically depicted in Fig. 7d would be the embodiment schematically depicted in Fig. 7b, but then with the source connector 540 arranged behind the second textile coating 222 (when seen from the first textile coating 211). In such embodiment, at least part of the second textile coating 222, and also at least part of the textile 200, would be between the source connector 540 and connector 340.

The lighting unit is preferably an LED-based lighting unit, and thus the light source(s) is preferably a LED.

The term "substantially" herein, such as in "substantially all emission" or in "substantially consists", will be understood by the person skilled in the art. The term "substantially" may also include embodiments with "entirely", "completely", "all", etc. Hence, in embodiments the adjective substantially may also be removed. Where applicable, the term "substantially" may also relate to 90% or higher, such as 95% or higher, especially 99% or higher, even more especially 99.5% or higher, including 100%. The term "comprise" includes also embodiments wherein the term "comprises" means "consists of".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices herein are amongst others described during operation. As will be clear to the person skilled in the art, the invention is not limited to methods of operation or devices in operation.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "to comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. A textile product (1) having a lighting function, comprising:
- a coated textile structure (2) comprising a textile (200) with a first textile coating (211) at a first side (210) and optionally a second textile coating (222) at a second side (220) of the textile (200); and
- a lighting unit (300) comprising a substrate (310) with a substrate surface (311) and a light source (330) comprised by the substrate surface (311),
wherein the lighting unit (300) is arranged within the coated textile structure (2) to provide light (331) through the first textile coating (211), and
wherein the substrate surface (311) further comprises an electrically conductive connector part (340) that is arranged to supply electrical power to the light source (330) when electrically connected to an electrical power source (500).

2. The textile product (1) according to any one of the preceding claims, wherein the coated textile structure (2) further comprises a light guide (400), arranged to guide at least part of the light (331) of the light source (330) away from the light source (330).

3. The textile product (1) according to any one of the preceding claims, wherein the lighting unit (300) comprises a plurality of electrically conductive connectors (340).

4. The textile product (1) according to any one of the preceding claims, wherein the second textile coating (222) further comprises a filler (230) and wherein the first textile coating (211) comprises, relative to the total weight of the first textile coating (211), less filler (230) than the second textile coating (222), preferably wherein the first textile coating (211) comprises substantially no filler (230).

5. The textile product (1) according to any one of the preceding claims, wherein the substrate (310) is attached to the textile with a low-melting temperature solder.

6. The textile product (1) according to any one of the preceding claims, wherein the lighting unit (300) comprises a plurality of light sources (330).

7. The textile product (1) according to any one of the preceding claims, comprising a plurality of lighting units (300), wherein preferably two or more lighting units (300) are electrically connected by electrically conductive wires (301) arranged within the coated textile structure (2).

8. The textile product (1) according to claim 7, wherein the textile comprises one or more electrically conductive yarns (202), and wherein one or more electrically conductive wires (301) comprise the one or more electrically conducting yarns (202).

9. The textile product (1) according to any one of claims 7-8, wherein the textile product (1) comprises supernumerary electrically conductive wires (301).

10. The textile product (1) according to any one of the preceding claims, being a product selected from the group of coated fabrics comprising a trailer textile, a (garden) furniture cover, a textile sailing, a tarpaulin, a curtain, an architectural outdoor textile, an architectural indoor textile, and a tent textile.

11. A textile product (1) having a lighting function according to claim 1, comprising:
- a coated textile structure (2) comprising a textile (200) with a first textile coating (211) at a first side (210) and optionally a second textile coating (222) at a second side (220) of the textile (200); and
- a lighting unit (300) comprising a substrate (310) with a substrate surface (311) and a light source (330) comprised by the substrate surface (311),
wherein the lighting unit (300) is arranged within the coated textile structure (2) to provide light (331) through the first textile coating (211), and
wherein the substrate surface (311) further comprises an electrically conductive connector part (340) of which at least part is not covered by the first coating (211), the connector part (340) being arranged to supply electrical power to the light source (330) when electrically connected to an electrical power source (500).

12. The textile product (1) according to any one of the preceding claims, further comprising an electrical power source (500), arranged in physical and electrical connection with the connector (340), and arranged to supply electrical power to the light source (330).

13. A method for the production of a textile product (1) according to any one of the preceding claims 1-11 comprising:
- applying a lighting unit (300) comprising a substrate (310) with a substrate surface (311) and a light source (330) comprised by the substrate surface (311); to a textile (200); and
- coating the textile (200) with the lighting unit (300) in a first coating process with a first textile coating (211) to provide a coated textile wherein the lighting unit (300) is arranged to provide light (331) through the first textile coating (211) and optionally coating the textile (200) in a second coating process with a second coating (222), with reference to the textile (200), opposite of the first textile coating (211),
wherein the substrate surface (311) further comprises an electrically conductive connector part (340) that is arranged to supply electrical power to the light source (330) when electrically connected to an electrical power source (500).

14. The method according to claim 13, comprising arranging with a low-melting temperature solder the lighting unit (300) on the textile (200) and coating the textile (200) and lighting unit (300) with the first textile coating (211), whereby the low-melting temperature solder and the first coating process conditions are selected to melt the low-melting temperature solder during the first coating process.

15. A method of providing light with a textile product (1) having a lighting function according to any one of claims 1-12 comprising providing such textile product (1) and an electrical power source (500), electrically connecting the electrical power source (500) and the electrically conductive connector part (340), and providing electrical power to the light source (330).

## Patentansprüche

1. Textilprodukt (1) mit einer Beleuchtungsfunktion, mit:
- einer beschichteten Textilstruktur (2), die ein Textil (200) mit einer ersten Textilbeschichtung (211) auf einer ersten Seite (210) und optional einer zweiten Textilbeschichtung (222) auf einer zweiten Seite (220) des Textils (200) umfasst; sowie
- einer Beleuchtungseinheit (300), die ein Substrat (310) mit einer Substratoberfläche (311) und eine durch die Substratoberfläche (311) umfasste Lichtquelle (330) aufweist,
wobei die Beleuchtungseinheit (300) innerhalb der beschichteten Textilstruktur (2) angeordnet ist, um Licht (331) durch die erste Textilbeschichtung (211) vorzusehen, und
wobei die Substratoberfläche (311) weiterhin einen elektrisch leitenden Anschlussteil (340) umfasst, der so angeordnet ist, dass er der Lichtquelle (330) elektrische Leistung zuführt, wenn er mit einer elektrischen Stromquelle (500) elektrisch verbunden ist.

2. Textilprodukt (1) nach Anspruch 1, wobei die beschichtete Textilstruktur (2) weiterhin einen Lichtleiter (400) umfasst, der so angeordnet ist, dass er zumindest einen Teil des Lichts (331) der Lichtquelle (330) von der Lichtquelle (330) weg leitet.

3. Textilprodukt (1) nach einem der vorangegangenen Ansprüche, wobei die Beleuchtungseinheit (300) mehrere elektrisch leitende Anschlüsse (340) umfasst.

4. Textilprodukt (1) nach einem der vorangegangenen Ansprüche, wobei die zweite Textilbeschichtung (222) weiterhin ein Füllmaterial (230) enthält, und wobei die erste Textilbeschichtung (211) relativ zu dem Gesamtgewicht der ersten Textilbeschichtung (211) weniger Füllmaterial (230) als die zweite Textilbeschichtung (222) enthält, wobei die erste Textilbeschichtung (211) vorzugsweise im Wesentlichen kein Füllmaterial (230) enthält.

5. Textilprodukt (1) nach einem der vorangegangenen Ansprüche, wobei das Substrat (310) an dem Textil mit Hilfe eines Lötmittels bei einer Temperatur mit niedrigem Schmelzpunkt befestigt wird.

6. Textilprodukt (1) nach einem der vorangegangenen Ansprüche, wobei die Beleuchtungseinheit (300) mehrere Lichtquellen (330) umfasst.

7. Textilprodukt (1) nach einem der vorangegangenen Ansprüche, das mehrere Beleuchtungseinheiten (300) umfasst, wobei vorzugsweise zwei Beleuchtungseinheiten (300) oder mehr durch innerhalb der beschichteten Textilstruktur (2) angeordnete, elektrisch leitende Drähte (301) elektrisch verbunden sind.

8. Textilprodukt (1) nach Anspruch 7, wobei das Textil ein oder mehrere elektrisch leitende Garne (202) umfasst, und wobei ein oder mehrere elektrisch leitende Drähte (301) das eine oder die mehreren elektrisch leitenden Garne (202) umfasst/umfassen.

9. Textilprodukt (1) nach einem der Ansprüche 7-8, wobei das Textilprodukt (1) überzählige, elektrisch leitende Drähte (301) umfasst.

10. Textilprodukt (1) nach einem der vorangegangenen Ansprüche, bei dem es sich um ein Produkt handelt, das aus der Gruppe von beschichteten Geweben, umfassend ein LKW-Anhänger-Textil, eine (Garten-) Möbelabdeckung, ein Textilsegel, eine Abdeckplane, einen Vorhang, ein architektonisches Outdoor-Textil, ein architektonisches Indoor-Textil sowie ein Zelttextil, ausgewählt wird.

11. Textilprodukt (1) mit einer Beleuchtungsfunktion nach Anspruch 1, mit:
- einer beschichteten Textilstruktur (2), die ein Textil (200) mit einer ersten Textilbeschichtung (211) auf einer ersten Seite (210) und optional einer zweiten Textilbeschichtung (222) auf einer zweiten Seite (220) des Textils (200) umfasst; sowie
- einer Beleuchtungseinheit (300), die ein Substrat (310) mit einer Substratoberfläche (311) und eine durch die Substratoberfläche (311) umfasste Lichtquelle (330) aufweist,
wobei die Beleuchtungseinheit (300) innerhalb der beschichteten Textilstruktur (2) angeordnet ist, um Licht (331) durch die erste Textilbeschichtung (211) vorzusehen, und
wobei die Substratoberfläche (311) weiterhin einen elektrisch leitenden Anschlussteil (340) umfasst, von dem zumindest ein Teil nicht von der ersten Beschichtung (211) überdeckt ist, wobei der Anschlussteil (340) so angeordnet ist, dass er der Lichtquelle (330) elektrische Leistung zuführt, wenn er mit einer elektrischen Stromquelle (500) elektrisch verbunden ist.

12. Textilprodukt (1) nach einem der vorangegangenen Ansprüche, das weiterhin eine elektrische Stromquelle (500) umfasst, die in physikalischer und elektrischer Verbindung mit dem Anschluss (340) angeordnet und so vorgesehen ist, dass sie der Lichtquelle (330) elektrische Leistung zuführt.

13. Verfahren zur Herstellung eines Textilprodukts (1) nach einem der Ansprüche 1-11, wonach:
- eine Beleuchtungseinheit (300) vorgesehen wird, die ein Substrat (310) mit einer Substratoberfläche (311) und eine durch die Substratoberfläche (311) umfasste Lichtquelle (330) aufweist, und
- das Textil (200) mit der Beleuchtungseinheit (300) in einem ersten Beschichtungsprozess mit einer ersten Textilbeschichtung (211) beschichtet wird, um ein beschichtetes Textil vorzusehen, wobei die Beleuchtungseinheit (300) so angeordnet ist, dass sie Licht (331) durch die erste Textilbeschichtung (211 bereitstellt, und das Textil (200) optional in einem zweiten Beschichtungsprozess mit einer zweiten Beschichtung (222) beschichtet wird, die sich, auf das Textil (200) bezogen, gegenüber der ersten Textilbeschichtung (211) befindet,
wobei die Substratoberfläche (311) weiterhin einen elektrisch leitenden Anschlussteil (340) umfasst, der so angeordnet ist, dass er der Lichtquelle (330) elektrische Leistung zuführt, wenn er mit einer elektrischen Stromquelle (500) elektrisch verbunden ist.

14. Verfahren nach Anspruch 13, wonach die Beleuchtungseinheit (300) auf dem Textil (200) mit Hilfe eines Lötmittels bei einer Temperatur mit niedrigem Schmelzpunkt angeordnet wird und das Textil (200) wie auch die Beleuchtungseinheit (300) mit der ersten Textilbeschichtung (211) beschichtet werden, wobei das Lötmittel mit niedriger Aufschmelztemperatur und die Bedingungen für den ersten Beschichtungsprozess so ausgewählt werden, dass das Lötmittel mit niedriger Aufschmelztemperatur während des ersten Beschichtungsprozesses geschmolzen wird.

15. Verfahren zum Bereitstellen von Licht bei einem Textilprodukt (1) mit einer Beleuchtungsfunktion nach einem der Ansprüche 1-12, wonach ein solches Textilprodukt (1) und eine elektrische Stromquelle (500) vorgesehen werden, die elektrische Stromquelle (500) und der elektrisch leitende Anschlussteil (34) elektrisch verbunden werden und der Lichtquelle (330) elektrische Leistung zugeführt wird.

## Revendications

1. Produit textile (1) ayant une fonction d'éclairage, comprenant :
- une structure textile revêtue (2) comprenant un textile (200) avec un premier revêtement textile (211) sur un premier côté (210) et facultativement un deuxième revêtement textile (222) sur un deuxième côté (220) du textile (200) ; et
- une unité d'éclairage (300) comprenant un substrat (310) avec une surface de substrat (311) et une source de lumière (330) comprise dans la surface de substrat (311), dans lequel l'unité d'éclairage (300) est agencée à l'intérieur de la structure textile revêtue (2) pour fournir une lumière (331) à travers le premier revêtement textile (211), et
dans lequel la surface de substrat (311) comprend en outre une partie de connecteur électriquement conducteur (340) qui est agencée pour fournir une alimentation électrique à la source de lumière (330) lorsqu'elle est électriquement reliée à une source d'alimentation électrique (500).

2. Produit textile (1) selon l'une quelconque des revendications précédentes, dans lequel la structure textile revêtue (2) comprend en outre un guide de lumière (400), agencé pour guider au moins une partie de la lumière (331) de la source de lumière (330) à l'écart de la source de lumière (330).

3. Produit textile (1) selon l'une quelconque des revendications précédentes, dans lequel l'unité d'éclairage (300) comprend une pluralité de connecteurs électriquement conducteurs (340).

4. Produit textile (1) selon l'une quelconque des revendications précédentes, dans lequel le deuxième revêtement textile (222) comprend en outre un remplisseur (230) et dans lequel le premier revêtement textile (211) comprend, par rapport au poids total du premier revêtement textile (211), moins de remplisseur (230) que le deuxième revêtement textile (222), de préférence dans lequel le premier revêtement textile (211) ne comprend sensiblement pas de remplisseur (230).

5. Produit textile (1) selon l'une quelconque des revendications précédentes, dans lequel le substrat (310) est attaché au textile par une soudure à basse température de fusion.

6. Produit textile (1) selon l'une quelconque des revendications précédentes, dans lequel l'unité d'éclairage (300) comprend une pluralité de sources de lumière (330).

7. Produit textile (1) selon l'une quelconque des revendications précédentes, comprenant une pluralité d'unités d'éclairage (300), dans lequel de préférence au moins deux unités d'éclairage (300) sont électriquement reliées par des câbles électriquement conducteurs (301) agencés à l'intérieur de la structure textile revêtue (2).

8. Produit textile (1) selon la revendication 7, dans lequel le textile comprend au moins un fil électriquement conducteur (202), et dans lequel au moins un câble électriquement conducteur (301) comprend l'au moins un fil électriquement conducteur (202).

9. Produit textile (1) selon l'une quelconque des revendications 7 et 8, dans lequel le produit textile (1) comprend des câbles électriquement conducteurs surnuméraires (301).

10. Produit textile (1) selon l'une quelconque des revendications précédentes, étant un produit sélectionné dans le groupe se composant de tissus revêtus comprenant un textile de remorque, une housse de mobilier (de jardin), un textile de voile, une bâche, un rideau, un textile d'extérieur architectural, un textile d'intérieur architectural et un textile de tente.

11. Produit textile (1) ayant une fonction d'éclairage selon la revendication 1, comprenant :
- une structure textile revêtue (2) comprenant un textile (200) avec un premier revêtement textile (211) sur un premier côté (210) et facultativement un deuxième revêtement textile (222) sur un deuxième côté (220) du textile (200) ; et
- une unité d'éclairage (300) comprenant un substrat (310) avec une surface de substrat (311) et une source de lumière (330) comprise dans la surface de substrat (311), dans lequel l'unité d'éclairage (300) est agencée à l'intérieur de la structure textile revêtue (2) pour fournir une lumière (331) à travers le premier revêtement textile (211), et
dans lequel la surface de substrat (311) comprend en outre une partie de connecteur électriquement conducteur (340) dont au moins une partie n'est pas recouverte par le premier revêtement (211), la partie de connecteur (340) étant agencée pour fournir une alimentation électrique à la source de lumière (330) lorsqu'elle est électriquement reliée à une source d'alimentation électrique (500).

12. Produit textile (1) selon l'une quelconque des revendications précédentes, comprenant en outre une source d'alimentation électrique (500), agencée en liaison physique et électrique avec le connecteur (340), et agencée pour fournir une alimentation électrique à la source de lumière (330).

13. Procédé pour la fabrication d'un produit textile (1) selon l'une quelconque des revendications précédentes 1 à 11, comprenant :
- l'application d'une unité d'éclairage (300) comprenant un substrat (310) avec une surface de substrat (311) et une source de lumière (330) comprise dans la surface de substrat (311), à un textile (200) ; et
- le revêtement du textile (200) avec l'unité d'éclairage (300) au cours d'un premier processus de revêtement avec un premier revêtement textile (211) pour fournir un textile revêtu dans lequel l'unité d'éclairage (300) est agencée pour fournir une lumière (331) à travers le premier revêtement textile (211) et facultativement le revêtement du textile (200) au cours d'un deuxième processus de revêtement avec un deuxième revêtement (222), en référence au textile (200), à l'opposé du premier revêtement textile (211),
dans lequel la surface de substrat (311) comprend en outre une partie de connecteur électriquement conducteur (340) qui est agencée pour fournir une alimentation électrique à la source de lumière (330) lorsqu'elle est électriquement reliée à une source d'alimentation électrique (500).

14. Procédé selon la revendication 13, comprenant l'agencement avec une soudure à basse température de fusion de l'unité d'éclairage (300) sur le textile (200) et le revêtement du textile (200) et de l'unité d'éclairage (300) avec le premier revêtement textile (211), de telle manière que la soudure à basse température de fusion et les conditions du premier processus de revêtement soient sélectionnées pour faire fondre la soudure à basse température de fusion au cours du premier processus de revêtement.

15. Procédé pour fournir de la lumière avec un produit textile (1) ayant une fonction d'éclairage selon l'une quelconque des revendications 1 à 12, comprenant la fourniture d'un tel produit textile (1) et d'une source d'alimentation électrique (500), la liaison électrique de la source d'alimentation électrique (500) et de la partie de connecteur électriquement conducteur (340), et la fourniture d'une alimentation électrique à la source de lumière (330).
